# EUROPEAN PATENT SPECIFICATION

(11) **EP 1 030 737 B1**
(45) Date of publication and mention of the grant of the patent: **17.09.2003**
(21) Application number: 97912413.8
(22) Date of filing: 14.11.1997
(51) Int. Cl.: B01D 46/12, B01D 46/50, B03C 3/47

(54) **AIR FILTER INCLUDING ELECTROSTATIC PRECIPITATION**
ELEKTROSTATISCHER LUFTFILTER
FILTRE A AIR A ELECTROFILTRAGE

(43) Date of publication of application: 30.08.2000
(73) Proprietor: Gideon Rosenberg doing business as Itec Initiatives, Tivon, 36100 (IL); Milow Ltd., Charleston, SC 29401 (US)
(72) Inventor: ROSENBERG, Gideon, 36100 Tivon (IL); LESKLY, Ilan, Los Angeles, CA 90049 (US)
(74) Representative: Schmitz, Jean-Marie
(86) International application number: IL9700371
(87) International publication number: WO99025478

(56) References cited:
- DE-A- 3 019 174
- DE-A- 4 003 564
- US-A- 2 974 747
- US-A- 3 805 492
- US-A- 4 661 250

## Description

The present invention relates to air filters for removing solid particles (e.g., dust) from air or other gases. The invention particularly relates to an air filter body of novel construction and to a filter element included in such a filter body.

The term "air filter" as used herein is intended to include filters not only for air, but also for other gases.

One of the largest applications for air filters at the present time is for cleaning the air supplied to internal combustion engines and air compressors. The most common type of air filter used for engines is the paper filter, made up of multiple layers of paper or other fiber. However, for the filter to remove small particles, the through passageways defined by the multiple-fiber layers must be very small. This produces a relatively large resistance to the air flow through the filter, which resistance increases with the accumulation of dirt particles in the filter. Such resistance to air flow not only decreases the efficiency of the system, but also imposes large forces on the filter itself which can result in its rupture. In addition, such filters generally are difficult to clean and are therefore usually discarded after a single or double use. Further, the dirt-holding capacity of such filters is very limited so that the filters must be frequently replaced particularly where the filters are used in a very dusty environment, such as in the desert, mining, road construction, etc.

Another type of filter used for air cleaning, particularly in applications involving a large air flow, is the electrostatic precipitator filter. This filter includes spaced electrodes containing opposite electrical charges so as to attract, to one of the electrodes, particles in the air passing in the space between the electrodes. Such electrostatic precipitators, however, generally require relatively large spacings between the electrodes plates to prevent voltage breakdown, and therefore do not remove all the particles (i.e., above a predetermined particle size) from the air passing through the filter. Also, in the event of an interruption of the power supply, the precipitator ceases to function, and the particles will pass through it. Moreover, such filters generally require a relatively large volume for their design, and therefore they are currently used mostly in large installations, such as power plants.

A further type of filter, called the disc filter, is widely used for removing solid particles from liquids, such as the water in a water irrigation system. This type of filter includes a plurality of discs arranged in a stack and having ribbed contacting faces defining small filtering passageways between the contacting faces of adjacent discs. The sizes of the passageways determine the sizes of the particles blocked. The particles blocking such passageways remain in them and thereby increase the resistance of the filter to the flow of the fluid therethrough until the particles are removed by cleaning, e.g., by reverse flushing.

Many types of disc filters are known and are used for removing solid particles from water or other liquids. Examples are described in US-A-4 661 250, US-A-4 740 302 and US-A-5 171 433. Insofar as we are aware, however, such disc-type filters have been used mostly or exclusively for removing solid particles from water or other liquids, and not dust or other solid particles from air or other gases.

According to one aspect of the present invention, there is provided an air filter body comprising a plurality of discs of electrically insulating material arranged in a stack and having ribbed contacting faces defining small filtering passageways between the contacting faces of adjacent discs; characterized in that each of said discs has an electrode layer insulated by the respective disc from the electrodes of the adjacent discs, each electrode being electrically connected to an electrical terminal at an edge of the respective disc; and electrical conductors for connecting the electrical terminals of alternating discs to one side of a voltage source, and the electrical terminals of the remaining alternating discs to the other side of the voltage source.

As will be described below, an air filter body constructed in accordance with the foregoing features exploits the advantages of both the disc-type filter and the electrostatic precipitator filter, and therefore may be considered to be a "hybrid" filter. Such a filter has a high particle-retaining capacity, as the electric field causes most of the particles to accumulate on the non-ribbed faces of the discs and not to block the small filtering passageways. The filter therefore exhibits a low resistance to air flow not only when the filter is relatively clean, but also after it has accumulated a relatively large quantity of the solid particles removed from the air. Such a filter also effectively removes the particles down to the smallest size of the passageways. Further, in the event of a failure of the power supply, passage of the solid particles through the filter is blocked by the small filtering passageways, thereby providing a more "fail safe" operation, as compared for example to the electrostatic precipitator filter. The filter body is also of a sturdy construction providing relatively reliable operation.

A still further advantage of the novel "hybrid" filter is that it may be more effectively cleaned than, for example, the disc type filter. Thus, during a cleaning mode, the electrical voltage applied to the terminals of the discs may be reversed, to thereby expel the particles from the contacting faces of the filter body discs and to enhance their removal during reverse flushing of the discs.

The invention also provides a novel filter element for use in the air filter body set forth above and a novel air filter device including the novel air filter body.
Fig. 1 is a longitudinal sectional view illustrating one form of air filter constructed in accordance with the present invention;
Fig. 2 is an enlarged schematic view more particularly illustrating the construction of the air filter body in the filter of Fig. 1;
Fig. 3 is a fragmentary perspective view illustrating the two types of filter discs included in the filter body of Fig. 2;
Figs. 4a, 4b and 5a, 5b illustrate, respectively, the two types of filter discs in the filter body of Fig. 2;
Fig. 6 illustrates one manner of producing the filter discs in the filter body of Fig. 2;
and Fig. 7 illustrates the manner in which the filter body of Fig. 2 removes the solid particles from the air.

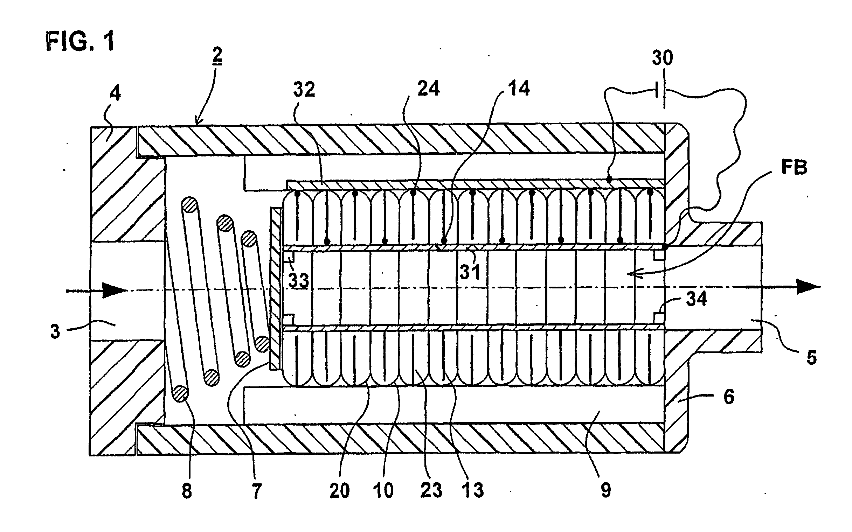

For purposes of example, the filter illustrated in Fig. 1 of the drawings and described herein is similar to the multiple-disc filter described in the above-cited US-A-4,661,250, but modified in accordance with the present invention to adapt it for use in removing dust particles or other relatively small particles from air or other gases. It will be appreciated that this type of multiple-disc filter is described herein only for purposes of example, and that the invention could use many other types of filter constructions.

The filter illustrated in Fig. 1 includes a cylindrical housing 2 having an inlet 3 formed in a cap 4 closing one end of the housing, and an outlet 5 formed in an end wall 6 closing the opposite end of the housing. Disposed within the housing is a filter body, generally designated FB, including a stack of annular filter discs each formed with a central opening. A non-apertured disc 7 is urged by a spring 8 to close the front end of the stack. The inner surface of housing 2 is formed with a plurality Of axially-extending, circumferentially-spaced ribs 9, so that the air inletted via inlet 3 is forced to flow in the annular region around the filter body FB, radially between the contacting faces of its filter discs and out through outlet 5.

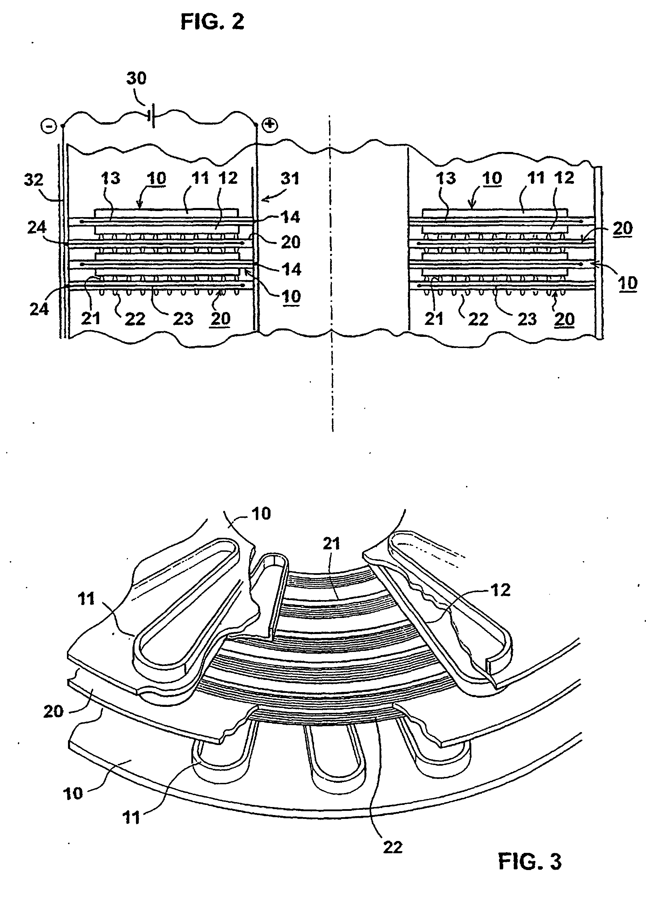

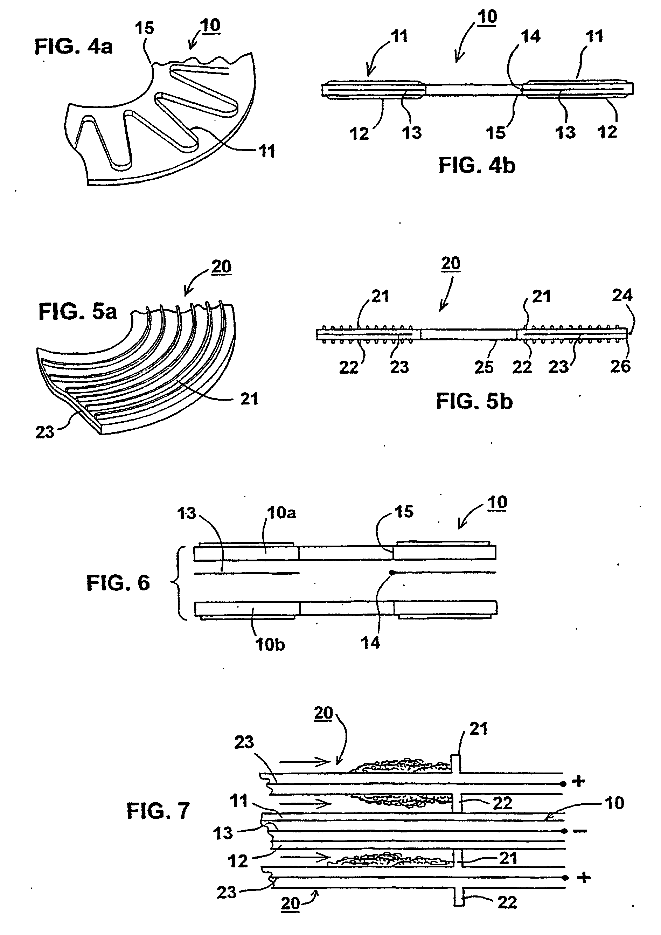

Filter body FB includes a stack of two types of discs, generally designated 10 and 20, respectively, in alternating relation in the stack, as shown particularly in Figs. 2 and 3. The construction of filter disc 10 is more particularly illustrated in Figs. 4a and 4b, and the construction of filter disc 20 is more particularly illustrated in Figs. 5a and 5b.

As shown in Figs. 4a and 4b, filter disc 10 includes substantially planar faces on its opposite sides each formed with a sinuous rib 11, 12. The disc is made of electrically insulating material, such as a suitable plastic material. It includes an electrode layer 13 embedded in the disc so as to be electrically insulated from the adjacent discs of the stack except for an electrical terminal 14 connected to the electrode and exposed at the inner edge 15 of the disc. Electrodes 13 in discs 10 are also substantially planar and extend substantially for the complete area of the two faces of the disc formed with the sinuous ribs 11, 12.

The second type of filter disc 20, as illustrated in Figs. 5a and 5b, is also of insulating material and is of the same dimensions as disc 1.0. In this case, however, it is formed on its opposed substantially planar faces with a plurality of concentric annular ribs 21, 22 of increasing diameter from the inner edge 25 to the outer edge 26. Discs 20 also include an electrode layer 23 of planar configuration. Electrode layer 23 extends for substantially the complete area of the ribbed face of the disc and is electrically insulated from adjacent discs in the stack. Its electrical terminal 24, electrically connected to electrode layer 23, is exposed on the outer face 26 of the disc.

As shown particularly in Fig. 3, each pair of contacting faces of the discs in the stack includes a sinuous rib (11, 12) of disc 10 and an annular rib (21, 22) of disc 20. The main-portions of the sinuous ribs 11, 12 extend substantially radially of their respective discs, whereas the annular ribs 21, 22 of discs 20 extend circularly around the disc. Accordingly, the annular ribs cross the sinuous ribs at substantially right angles to define small filtering passageways between the ribs. Each such filtering passageway has a height equal to the height of the sinuous ribs 11, 12, a length equal to the distance between the sinuous ribs 11, 12, and a breadth equal to the thickness of the annular ribs 21, 22.

The illustrated filter further includes a DC voltage source 30 electrically connected to the electrodes 13 and 23 of the filter discs 10 and 20, respectively. Our terminal (e.g., "+") is connected by electrical conductor 31 to terminals 14 of the electrodes 13 in the discs 10, and the other terminal (e.g., "-") is connected by electrical conductor 32 to terminals 24 of electrodes 23 in discs 20 alternating with discs 10.

As shown in Fig. 1, electrical conductor 32 is carried by one of the axially-extending ribs 9 formed on the inner face of the housing 2 so that it engages all the terminals 24 on the outer edges of the alternating discs. The inner electrical conductor 31 is supported on an annular rib 33 formed on end disc 7 and another annular rib 34 formed on the inner surface of the housing end wall 6 around the outlet 5, such that electrical conductor 31 contacts the terminals 14 on the inner edges of the remaining alternate discs.

Fig. 6 illustrates one way of incorporating the electrodes within their respective discs. Thus, the electrode 13 is sandwiched between two disc sections 10a, 10b bonded to each other so that the electrode is completely embedded within the disc, and only its terminal 14 is exposed at the inner edge 15 of the disc. The same technique can be used for incorporating electrodes 23 within their discs. Other techniques could also be used, for example plating the electrode layer on a disc section and then bonding the other section thereto.

The described filter thus removes the solid particles in the air by both a mechanical filtration action and an electrostatic precipitation action. The air inletted via inlet 3 is directed by the non-apertured end disc 7 to the outer annular region between the filter body FB and the inner surface of the housing 2, through the axial passages defined by the axial ribs 9, and then radially between the contacting faces of the filter discs 10, 20 in the filter body FB, and out through the outlet 5. The narrow filtering passageways described above between the sinuous ribs 11, 12 of the filtering discs 10, and the annular ribs 21, 22 of the filtering discs 20, prevent solid particles in the air stream from flowing through the filter body FB. In addition, the electrostatic field produced between the negatively-charged electrodes 13 in discs 10 and the positively-charged electrodes 23 in discs 20 attract the dirt particles to the surface of discs 20, as shown in Fig. 7, where they tend to accumulate on the inlet sides of the annular ribs 21, 22. The particles are thus removed before they reach the small filtering passageways, and therefore do not block the passageways nor increase the flow resistance through the passageways. However, should there be a failure of the power supply, the filtering passageways will be effective to block the particles from reaching the outlet.

The filter may be cleaned whenever desired by directing air from the outlet 5 towards the inlet 3, thereby reverse-flushing the filter body FB. At the same time the filter body is reversed-flushed, the electrical connections to the electrodes 13, 23 may be reversed so that the electrostatic field produced by these electrodes will now repel the particles from the surfaces to which they had been attracted, thereby enhancing the reverse flushing of the filter body.

The air supply used for reversely-flushing the filter may be from a separate source of compressed air, e.g., supplied by a tank of compressed air. The filter body may also be cleaned by reversely-flushing it first with steam or a spray of liquid droplets before reversely-flushing it with air.

The illustrated filter provides a sturdy construction, is reliable in operation, efficiently removes even small particles from the air, provides a large particle-retaining capacity for its size, introduces a low resistance to the air flow through the filter body even when a relatively large quantity of dirt particles has accumulated, provides a "fail safe" operation in the event of power failure, and permits efficient cleaning of the filter whenever desired.

While the invention has been described with respect to one preferred embodiment, it will be appreciated that this embodiment is set forth merely for purposes of example, and that many other variations, modifications and applications of the invention may be made.

## Claims

1. An air filter body (FB) comprising:
a plurality of discs (10, 20) of electrically insulating material arranged in a stack and having ribbed contacting faces (11, 12; 21, 22) defining small filtering passageways between the contacting faces (11,12; 21, 22) of adjacent discs (10, 20),
**characterized in that** each of said discs (10, 20) has an electrode layer (13, 23) insulated by the respective disc (10, 20) from the electrodes (13, 23) of the adjacent discs (10, 20), each electrode (1, 23) being electrically connected to an electrical terminal (14, 24) at an edge of the respective disc (10, 20), and
in comprising electrical conductors (31, 32) for connecting the electrical terminals (14) of alternating discs (10) to one side of a voltage source (30), and the electrical terminals (24) of the remaining alternating discs (20) to the other side of said voltage source (30).

2. The filter body (FB) according to claim 1, **characterized in that** said electrodes (13, 23) are substantially planar and extend for substantially the complete area of the ribbed faces (11, 12; 21, 22) of their respective discs (10, 20).

3. The filter body (FB) according to claim 1, **characterized in that** the ribs (11, 12) in one disc face of each pair of contacting faces (11, 12; 21, 22) extend substantially perpendicularly to the ribs (21, 22) of the other disc face of the pair of contacting faces (11, 12; 21, 22).

4. The filter body (FB) according to claim 1, **characterized in that** said discs (10, 20) are of annular configuration, the electrical terminals (14) of alternating discs (10) being on the inner edges of their respective discs (10), and the electrical terminals (24) of the remaining alternating discs (20) being on the outer edges of their respective discs (20).

5. The filter body (FB) according to claim 4, **characterized in that** the ribs (11, 12) in one disc face of each pair of contacting faces (11, 12; 21, 22) are of sinuous configuration having their major portions extending substantially radially of the respective disc (10), and the ribs (21, 22) on the other disc face of the pair of contacting faces (11, 12; 21, 22) are of annular configuration to extend substantially perpendicularly to said major portions of the sinuous ribs (11, 12) in said one disc face.

6. The filter body (FB) according to claim 5, **characterized in that** alternate discs (10) are formed with said sinuous ribs (11, 12) on both faces, and the remaining alternate discs (20) are formed with said annular ribs (21, 22) on both faces.

7. The filter body (FB) according to claim 1, **characterized in that** said electrodes (13, 23) are embedded in their respective discs (10, 20).

8. A filter element comprising:
a disc (10) of insulating material having substantially planar outer faces formed with ribs (11, 12) contactible with ribs (21, 22) on the outer faces of other discs (20) when stacked therewith to define filtering passageways between the contacting faces (11, 12; 21, 22) of the discs (10, 20),
**characterized in that** an electrode layer (13) is carried by said disc (10) and is covered by the insulating material thereof, said electrode layer (13) being electrically connected to an exposed electrical terminal (14) at one edge of the disc (10).

9. The filter element according to claim 8, **characterized in that** said electrode (13) extends for substantially the complete area of the ribbed faces of the disc (10).

10. An air filter device comprising: a housing having an inlet (3) and an outlet (5) , a filter body (FB) according to claim 1, within said housing for filtering the air fed into the inlet (3) before discharging the air through the outlet (5), and an electrical voltage source (30) connected to said terminals (14, 24) of the electrodes (13, 23) in the insulating discs (10, 20) to electrically attract solid particles in the air through the contacting faces (11, 12; 21, 22) of the discs (10, 20).

## Patentansprüche

1. Luftfilterkörper (FB) umfassend:
eine Vielzahl von Scheiben (10, 20) eines elektrisch isolierenden Materials, welche in einem Stapel angeordnet sind und gerippte Kontaktflächen (11, 12; 21, 22) aufweisen, die kleine Filterdurchlässe zwischen den Kontaktflächen (11, 12; 21, 22) benachbarter Scheiben (10, 20) ausbilden,
**dadurch gekennzeichnet, dass** jede der Scheiben (10, 20) eine Elektrodenschicht (13, 23) aufweist, die durch die jeweilige Scheibe (10, 20) von den Elektroden (13, 23) der benachbarten Scheiben (10, 20) isoliert ist, wobei jede Elektrode (13, 23) elektrisch mit einem elektrischen Anschluss (14, 24) an einem Rand der jeweiligen Scheibe (10, 20) verbunden ist, und
umfassend elektrische Leiter (31, 32) zur Verbindung der elektrischen Anschlüsse (14) alternierender Scheiben (10) mit einer Seite einer Spannungsquelle (30), und der elektrischen Anschlüsse (24) der übrigen alternierenden Scheiben (20) mit der anderen Seite der Spannungsquelle (30).

2. Filterkörper (FB) nach Anspruch 1, **dadurch gekennzeichnet, dass** die Elektroden (13, 23) im wesentlichen planar sind und sich im wesentlichen über den gesamten Bereich der gerippten Flächen (11, 12; 21, 22) ihrer jeweiligen Scheiben (10, 20) erstrecken.

3. Filterkörper (FB) nach Anspruch 1, **dadurch gekennzeichnet, dass** sich die Rippen (11, 12) in einer Scheibenfläche jedes Paares der Kontaktflächen (11, 12; 21, 22) im wesentlichen rechtwinklig zu den Rippen (21, 22) der anderen Scheibenfläche des Paares der Kontaktflächen (11, 12; 21, 22) erstrecken.

4. Filterkörper (FB) nach Anspruch 1, **dadurch gekennzeichnet, dass** die Scheiben (10, 20) eine ringförmige Form aufweisen, wobei die elektrischen Anschlüsse (14) alternierender Scheiben (10) auf den inneren Rändem ihrer jeweiligen Scheiben (10) angeordnet sind, und die elektrischen Anschlüsse (24) der übrigen alternierenden Scheiben (20) auf den äußeren Rändern ihrer jeweiligen Scheiben (20) angeordnet sind.

5. Filterkörper (FB) nach Anspruch 4, **dadurch gekennzeichnet, dass** die Rippen (11, 12) in einer Scheibenfläche jedes Paares der Kontaktflächen (11, 12; 21, 22) eine gewundene Form aufweisen, wobei sich ihre Hauptteile im wesentlichen radial von der jeweiligen Scheibe (10) aus erstrecken, und die Rippen (21, 22) auf der anderen Scheibenfläche des Paares der Kontaktflächen (11, 12; 21, 22) eine ringförmige Form aufweisen, um sich im wesentlichen rechtwinklig zu den Hauptteilen der gewundenen Rippen (11, 12) in der einen Scheibenfläche zu erstrecken.

6. Filterkörper (FB) nach Anspruch 5, **dadurch gekennzeichnet, dass** alternierende Scheiben (10) auf beiden Flächen mit den gewundenen Rippen (11, 12) ausgebildet sind, und die übrigen alternierenden Scheiben (20) mit den ringförmigen Rippen (21, 22) auf beiden Flächen ausgebildet sind.

7. Filterkörper (FB) nach Anspruch 1, **dadurch gekennzeichnet, dass** die Elektroden (13, 23) in ihren jeweiligen Scheiben (10, 20) eingebettet sind.

8. Filterelement umfassend:
eine Scheibe (10) eines isolierenden Materials, welche im wesentlichen planare äußere Flächen, die mit Rippen (11, 12) ausgebildet sind, aufweist, welche mit Rippen (21, 22) auf den äußeren Flächen anderer Scheiben (20) kontaktierbar sind, wenn sie damit gestapelt sind, um Filterdurchlässe zwischen den Kontaktflächen (11, 12; 21, 22) der Scheiben (10, 20) auszubilden,
**dadurch gekennzeichnet, dass** eine Elektrodenschicht (13) von der Scheibe (10) getragen und von dem isolierenden Material beschichtet ist, wobei die Elektrodenschicht (13) elektrisch mit einem exponierten elektrischen Anschluss (14) an einem Rand der Scheibe (10) verbunden ist.

9. Filterelement nach Anspruch 8, **dadurch gekennzeichnet, dass** die Elektrode (13) sich im wesentlichen über den gesamten Bereich der gerippten Flächen der Scheibe (10) erstreckt.

10. Luftfiltervorrichtung umfassend:
ein Gehäuse, welches einen Einlass (3) und einen Auslass (5) aufweist, einen Filterkörper (FB) nach Anspruch 1, innerhalb des Gehäuses um die in den Einlass (3) eingeführte Luft zu filtern, bevor die Luft durch den Auslass (5) austritt, und eine elektrische Spannungsquelle (30) verbunden mit den Anschlüssen (14, 24) der Elektroden (13, 23) in den isolierenden Scheiben (10, 20), um feste Partikel in der Luft durch die Kontaktflächen (11, 12; 21, 22) der Scheiben (10, 20) elektrisch anzuziehen.

## Revendications

1. Corps de filtre pour l'air (FB) comprenant :
plusieurs disques (10, 20) en une matière procurant une isolation électrique, arrangés en une pile et possédant des faces nervurées de mise en contact (11, 12 ; 21, 22) définissant de petits passages filtrants entre les faces de mise en contact (11, 12 ; 21, 22) de disques adjacents (10, 20) ;
**caractérisé en ce que** chacun desdits disques (10, 20) possède une couche (13, 23) faisant office d'électrode, isolée par le disque respectif (10, 20) des électrodes (13, 23) des disques adjacents (10, 20), chaque électrode (13, 23) étant reliée par voie électrique à une borne électrique (14, 24) à un bord du disque respectif (10, 20), et
**en ce qu'**il comprend des conducteurs électriques (31, 32) pour relier les bornes électriques (14) de disques alternants (10) à un côté d'une source de tension (30), et les bornes électriques (24) des disques alternants restants (20) à l'autre côté de la source de tension (30).

2. Corps de filtre (FB) selon la revendication 1, **caractérisé en ce que** lesdites électrodes (13, 23) sont essentiellement planes et s'étendent essentiellement sur la surface complète des faces nervurées (11, 12 ; 21, 22) de leurs disques respectifs (10, 20).

3. Corps de filtre (FB) selon la revendication 1, **caractérisé en ce que** les nervures (11, 12) dans une face de disque de chaque paire de faces de mise en contact (11, 12 ; 21, 22) s'étendent essentiellement perpendiculairement aux nervures (21, 22) de l'autre face de disque de la paire de faces de mise en contact (11, 12 ; 21, 22).

4. Corps de filtre (FB) selon la revendication 1, **caractérisé en ce que** lesdits disques (10, 20) sont de configuration annulaire, les bornes électriques (14) de disques alternants (10) étant disposées sur les bords internes de leurs disques respectifs (10), et les bornes électriques (24) des disques alternants restants (20) étant disposées sur les bords externes de leurs disques respectifs (20).

5. Corps de filtre (FB) selon la revendication 4, **caractérisé en ce que** les nervures (11, 12) d'une face de disque de chaque paire de faces de mise en contact (11, 12 ; 21, 22) sont de configuration sinusoïdale dont les portions majeures s'étendent essentiellement en direction radiale par rapport au disque respectif (10) et les nervures (21, 22) sur l'autre face de disque de la paire de faces de mise en contact (11, 12 ; 21, 22) sont de configuration annulaire et s'étendent essentiellement perpendiculairement auxdites portions majeures des nervures sinusoïdales (11, 22) dans ladite. première face de disque.

6. Corps de filtre (FB) selon la revendication 5, **caractérisé en ce que** des disques alternants (10) présentent lesdites nervures sinusoïdales (11, 12) sur les deux faces et les disques alternants restants (20) présentent lesdites nervures annulaires (21, 22) sur les deux faces.

7. Corps de filtre (FB) selon la revendication 1, **caractérisé en ce que** lesdites électrodes (13, 23) sont enrobées dans leurs disques respectifs (10, 20).

8. Élément filtrant comprenant :
un disque (10) constitué d'une matière isolante, possédant des faces externes essentiellement planes présentant des nervures (11, 12) aptes à entrer en contact avec des nervures (21, 22) sur les faces externes d'autres disques (20) à l'état empilé avec ces derniers pour définir des passages filtrants entre les faces de mise en contact (11, 12 ; 21, 22) des disques (10, 20) ;
**caractérisé en ce qu'**une couche (13) faisant office d'électrode est supportée par ledit disque (10) et est recouverte par la matière isolante du premier cité, ladite couche (13) faisant office d'électrode étant reliée par voie électrique à une borne électrique exposée (14) à un bord du disque (10).

9. Élément filtrant selon la revendication 8, **caractérisé en ce que** ladite électrode (13) s'étend essentiellement sur la surface complète des faces nervurées du disque (10).

10. Dispositif de filtration de l'air comprenant :
un logement comportant une entrée (3) et une sortie (5), un corps de filtre (FB) selon la revendication 1 à l'intérieur dudit logement pour filtrer l'air introduit par l'entrée (3) avant d'évacuer l'air via la sortie (5), et une source de tension électrique (30) reliée auxdites bornes (14, 24) des électrodes (13, 23) dans les disques isolants (10, 20) dans le but d'attirer par voie électrique des particules solides présentes dans l'air à travers les faces de mise en contact (11, 12 ; 21, 22) des disques (10, 20).
